# EUROPEAN PATENT APPLICATION

(11) **EP 2 226 859 A2**
(43) Date of publication of application: **08.09.2010**
(21) Application number: 09010982.8
(22) Date of filing: 27.08.2009
(51) Int. Cl.: H01L 33/38, H01L 33/42, H01L 33/14

(54) **Semiconductor light emitting device**

(30) Priority: 03.03.2009 JP 2009049507
(71) Applicant: Kabushiki Kaisha Toshiba, Minato-ku Tokyo (JP)
(72) Inventor: Shibata, Kyohei, Minato-ku Tokyo (JP)
(74) Representative: HOFFMANN EITLE

(57) **Abstract**

A semiconductor light emitting device includes: a semiconductor multilayer structure including a first semiconductor layer, a second semiconductor layer, and a light emitting layer provided between the first semiconductor layer and the second semiconductor layer; a first electrode connected to the first semiconductor layer of the semiconductor multilayer structure; a second electrode provided on the second semiconductor layer of the semiconductor multilayer structure; and a third electrode connected to the second electrode. The second electrode is provided between the first electrode and the third electrode as viewed in a direction perpendicular to a major surface of the semiconductor multilayer structure, and includes: a first region having at least one notch extending toward a route connecting between the first electrode and the third electrode; a second region provided around the first electrode and having no notch; and a third region provided around the third electrode and having no notch.

## Description

### CROSS-REFERENCE TO RELATED APPLICATIONS

This application is based upon and claims the benefit of priority from the prior Japanese Patent Application No.2009-049507, filed on March 3, 2009; the entire contents of which are incorporated herein by reference.

### BACKGROUND OF THE INVENTION

### Field of the Invention

This invention relates to a semiconductor light emitting device.

### Background Art

Conventionally, in a semiconductor light emitting device including a compound semiconductor layer (e.g., gallium nitride-based), metal films as an n-side electrode and a p-side electrode are formed on the semiconductor layer surface, and a voltage is applied between the metal films to cause light emission from the semiconductor light emitting device.

In such metal films, ohmic contact between the metal film and the semiconductor layer cannot be obtained simply by forming the metal film on the semiconductor layer. For instance, heat treatment may be used to form an alloy layer at the interface between the metal film and the semiconductor layer, thereby obtaining ohmic contact of the metal film with the semiconductor layer surface.

However, in such a semiconductor light emitting device, because of the high electrical resistance of the p-type layer, for instance, current diffusion is less likely to occur in this p-type layer. Thus, light emission may dominantly occur only near the portion of the p-type layer immediately below the p-side electrode connected thereto.

To avoid such unevenness in light emission, a metal film having a lower electrical resistance than the p-type layer may be extracted from the main electrode to the semiconductor layer surface (e.g., JP-A-2005-252300(Kokai)).

### SUMMARY OF THE INVENTION

According to an aspect of the invention, there is provided a semiconductor light emitting device including: a semiconductor multilayer structure including a first semiconductor layer, a second semiconductor layer, and a light emitting layer provided between the first semiconductor layer and the second semiconductor layer; a first electrode connected to the first semiconductor layer of the semiconductor multilayer structure; a second electrode provided on the second semiconductor layer of the semiconductor multilayer structure; and a third electrode connected to the second electrode, the second electrode being provided between the first electrode and the third electrode as viewed in a direction perpendicular to a major surface of the semiconductor multilayer structure, and including: a first region having at least one notch extending toward a route connecting between the first electrode and the third electrode; a second region provided around the first electrode and having no notch; and a third region provided around the third electrode and having no notch.

### BRIEF DESCRIPTION OF THE DRAWINGS

FIGS. 1A to 1C show a relevant part of a semiconductor light emitting device;
FIGS. 2A and 2B are cross-sectional schematic views of the relevant part for describing the operation of the semiconductor light emitting device;
FIGS. 3A and 3B illustrate the emission characteristics of the semiconductor light emitting device;
FIGS. 4A to 4D illustrate the emission characteristics of the semiconductor light emitting devices;
FIGS. 5A and 5B illustrate the relationship between the width of the notch and the emission pattern;
FIGS. 6A to 6E are plan views of the relevant part for describing the variations of the notch pattern;
FIGS. 7A and 7B show a relevant part of the semiconductor light emitting device; and
FIGS. 8A to 8G illustrate the emission characteristics of semiconductor light emitting devices.

### DETAILED DESCRIPTION OF THE INVENTION

Embodiments of the invention will now be described with reference to the drawings.

### First embodiment

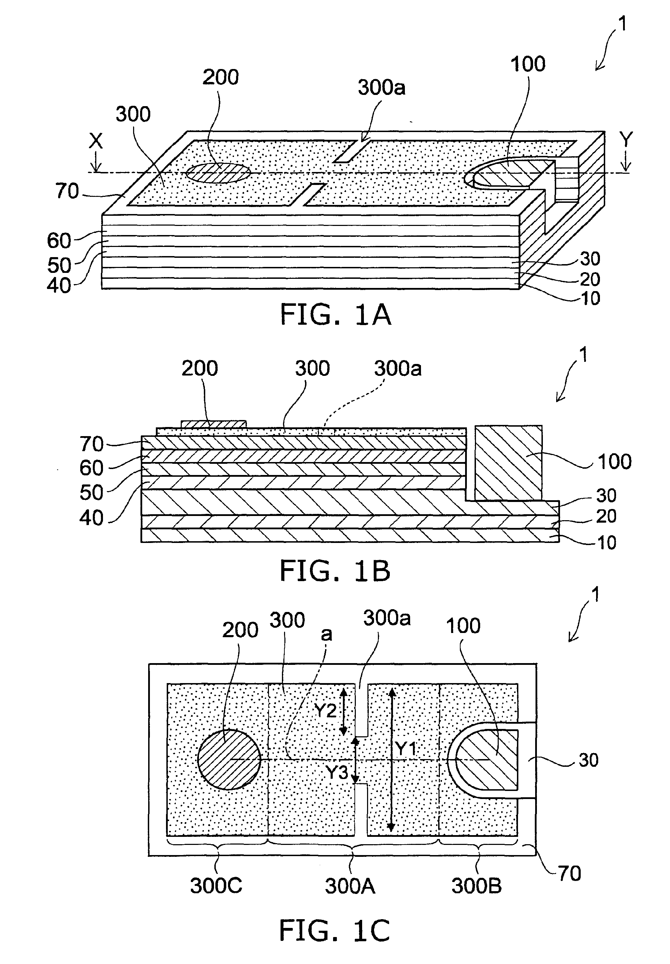

FIGS. 1A to 1C show a relevant part of a semiconductor light emitting device. More specifically, FIG. 1A is a perspective schematic view of the relevant part of the semiconductor light emitting device, FIG. 1B is a cross-sectional schematic view of the relevant part of the semiconductor light emitting device, and FIG. 1C is a plan view of the relevant part of the semiconductor light emitting device. FIG. 1B illustrates the X-Y cross section of FIG. 1A. FIG. 1C illustrates, in plan view, the relevant part of the semiconductor light emitting device 1 as viewed from the electrode 300 toward the substrate 10 of the semiconductor light emitting device 1.

As illustrated in FIGS. 1A and 1B, the semiconductor light emitting device 1 has a semiconductor multilayer structure in which a GaN buffer layer 20, an n-type GaN layer (first semiconductor layer) 30, an n-type GaN guide layer 40, an active layer (light emitting layer) 50, a p-type GaN guide layer 60, and a p-type GaN layer (second semiconductor layer) 70 are provided in this order on the substrate 10. That is, the active layer 50 is sandwiched between an n-type and p-type semiconductor stacked body.

The substrate 10 is illustratively made of sapphire. The active layer 50 can be illustratively implemented as an In_{0.15}Ga_{0.85}N/In_{0.02}Ga_{0.98}N MQW (multi-quantum well) structure, and emits blue, violet or other light, for instance. An n-side electrode (first electrode) 100 as a main electrode is selectively formed on part of the n-type GaN layer 30.

An electrode (second electrode) 300 for diffusing the current is placed on the upper surface of the p-type GaN layer 70, and a p-side electrode (third electrode) 200 as a main electrode is selectively placed on part of the electrode 300. The n-side electrode 100 and the p-side electrode 200 are both selectively placed above the major surface of the substrate 10 (on the upper surface side of the semiconductor multilayer structure) on which the semiconductor layers are stacked. The n-side electrode 100 is exposed to the upper surface side of the semiconductor multilayer structure. The electrode 300 is illustratively made of a metal film, or a conductive film primarily composed of ITO (indium tin oxide). In the case where ITO is used as the material of the electrode 300, light emitted from the active layer 50 can be transmitted through the electrode 300 and extracted outside. In the case where a light-shielding metal film is used as the electrode 300, light emitted from the active layer 50 can be extracted outside from the substrate 10 side.

The p-side electrode 200 can be made of AuZn/Mo/Au (a stacked body of AuZn, Mo, and Au stacked in this order) or Ti/Pt/Au. The n-side electrode 100 can be made of AuGe/Mo/Au or Ti/Pt/Au.

Between the semiconductor layers 40, 50 and the like and the n-side electrode 100, for instance, a dielectric layer, not shown, can be interposed. An alloy layer, not shown, can be formed at the interface between the n-side electrode 100 and the n-type GaN layer 30.

The electrode 300 extends from the p-side electrode 200 toward the n-side electrode 100. The end of the electrode 300 is arranged so as to surround the periphery of the n-side electrode 100.

At least one notch 300a is provided in part of the electrode 300 of the semiconductor light emitting device 1. Such a notch 300a formed in the electrode 300 can regulate the flow of the current diffusing in the electrode 300 to make the emission distribution uniform.

For instance, in the example shown in FIGS. 1A to 1C, the electrode 300 includes two opposed notches 300a in a direction generally perpendicular to the line a connecting between the center of the p-side electrode 200 and the center of the n-side electrode 100. These notches 300a are formed from the edge of the electrode 300 toward the inside of the electrode 300. However, the notches 300a do not extend to the position of the line a. That is, the electrode 300 is not divided by the notches 300a near the line a, but is a continuous body. In this electrode 300, a current flows along a main route near the line a. In other words, on the p-type GaN layer 70, a continuous body of ITO film which can serve as a main route of current is ensured in the direction from the p-side electrode 200 to the n-side electrode 100.

The electrode 300 includes a first region 300A provided between the n-side electrode 100 and the p-side electrode 200, a second region 300B provided around the n-side electrode 100, and a third region 300C provided around the p-side electrode 200. The notch 300a is formed in the first region 300A. The notch 300a extends toward the route connecting between the n-side electrode 100 and the p-side electrode 200. On the other hand, no notch is formed in the second region 300B and the third region 300C.

The ratio between the longitudinal and lateral length of the semiconductor light emitting device 1 in plan view is illustratively 2:1 (see FIG. 1C). For instance, in the plane of the semiconductor light emitting device 1, if the longitudinal length is 500 µm, the lateral length is 250 µm.

Furthermore, let Y1 denote the width of the electrode 300 shown in FIG. 1. Then, the length Y2 of the notch 300a is, for instance, approximately 1/3 of Y1. The distance Y3 between the ends of the notches 300a extended into the electrode 300 can be 10 µm or more.

Such a semiconductor light emitting device 1 can emit light when it is mounted on a mounting member at the substrate 10 side and wires or the like are connected respectively to the n-side electrode 100 and the p-side electrode 200. Here, by using ITO for the electrode 300, light transmitted through the electrode 300 can be extracted.

Alternatively, the semiconductor light emitting device 1 can be flip-chip mounted. In this case, bumps are connected to the n-side electrode 100 and the p-side electrode 200, and the semiconductor light emitting device 1 is mounted on the mounting member. Light emission can be extracted from the substrate 10 side.

Next, the operation of the semiconductor light emitting device 1 is described. In the following, the operation of the semiconductor light emitting device 1 is described while the semiconductor light emitting device 1 including a notch 300a is compared with a semiconductor light emitting device without the notch 300a.

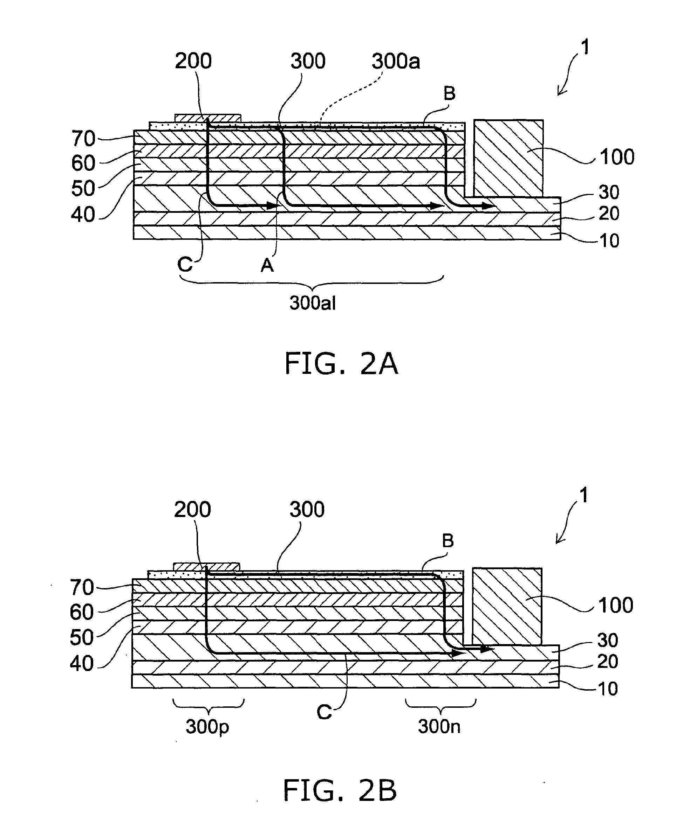

FIGS. 2A and 2B are cross-sectional schematic views of the relevant part for describing the operation of the semiconductor light emitting device.

First, the semiconductor light emitting device of a comparative example without the notch 300a is described (see FIG. 2B).

In this comparative example, the electrode 300 has a lower electrical resistance than the p-type GaN layer 70. Hence, when a voltage is applied between the p-side electrode 200 and the n-side electrode 100, the current flowing in through the p-side electrode 200 is likely to diffuse in the in-plane direction of the electrode 300.

In this case, the current flows in the plane of the electrode 300 to its end portion near the n-side electrode 100, and flows into the n-side electrode 100 through a current path below the end portion of the electrode 300 in the order of the p-type GaN layer 70, the active layer 50, the n-type GaN layer 30, and the n-side electrode 100. That is, the current path is as indicated by arrow B shown in FIG. 2B.

Alternatively, in this comparative example, current diffusion in the film plane of the p-type GaN layer 70 may be less likely to occur. In this case, the current flowing from the p-side electrode 200 into the electrode 300 may flow immediately downward from the p-side electrode 200, passes through the active layer 50, and flows through the plane of the n-type GaN layer 30 into the n-type electrode 100. That is, the current path is as indicated by arrow C shown in FIG. 2B.

Thus, in the semiconductor light emitting device of the comparative example without the notch 300a, the current path selects a local route as indicated by arrows B, C. Hence, in the semiconductor light emitting device of the comparative example, light emission dominantly occurs, for instance, immediately below the p-side electrode 200 side or immediately below the end portion 300n of the electrode 300 on the n-type electrode 100 side. That is, the emission distribution is likely to be nonuniform.

Here, as the electrical resistance of the electrode 300 becomes lower, the current path indicated by arrow B tends to dominate.

In contrast, in the semiconductor light emitting device 1 of this embodiment, as described above with reference to FIGS. 1A to 1C, a notch 300a is provided in the electrode 300 between the p-side electrode 200 and the n-side electrode 100.

Because such a notch 300a is provided, the electrode 300 includes a portion where the resistance is apparently high. That is, the conductivity in the in-plane direction of the electrode 300 is partially reduced, producing the so-called "accumulation effect" of current in the electrode 300.

If such "accumulation" of current occurs, the accumulated current is forced to travel or diffuse to below the semiconductor light emitting device 1. That is, in the semiconductor light emitting device 1 shown in FIG. 2A, besides the line of arrow B, a new current path as indicated by arrow A occurs. Thus, the current path can be dispersed to make the light emission more uniform.

That is, in the semiconductor light emitting device 1, by the notch 300a provided in the electrode 300, the distribution of current in the active layer 50 can be dispersed to make the emission distribution uniform.

The arrow A illustrated in FIG. 2A is illustrative only. It is understood that a current path can occur in the portion other than the line of arrow A.

Furthermore, in the semiconductor light emitting device 1, the notch 300a is not extended near the line a connecting between the n-side electrode 100 and the p-side electrode 200 (see FIG. 1C).

That is, a main route of current flow is formed in the in-plane direction of the electrode 300 extending from the p-side electrode 200. Hence, the current flowing from the p-type GaN layer 70 to the n-type GaN layer 30 side tends to be supplied from the center of the electrode 300.

Thus, in the semiconductor light emitting device 1, a current component diffusing from the device center to the periphery occurs, allowing more uniform light emission. Injection of current more uniformly into the active layer 50 increases the emission efficiency, and the overall emission intensity is higher than in the semiconductor light emitting device without the notch 300a.

On the other hand, local current concentration as illustrated in FIG. 2B may cause the decrease of emission efficiency due to the high-density current, or may decrease the device reliability due to heat generation, increased defects and the like.

In contrast, in the semiconductor light emitting device 1, as described above, the current can be passed more uniformly from the electrode 300 to the n-type GaN layer 30 side, and local current concentration can be prevented. Consequently, the aforementioned decrease of emission efficiency and device reliability can be prevented.

Furthermore, the notch 300a can be readily patterned by known film formation and lithography techniques, and hence does not significantly increase the cost of manufacturing the semiconductor light emitting device 1.

In relation to the above embodiment, other electrode configurations are known, such as a mesh configuration in which an electrode extended from the p-side electrode of the semiconductor light emitting device is periodically provided with through holes, and a striped or comb-like configuration of the aforementioned extended electrode (see, e.g., JP-A-2004-055646(Kokai), JP-A-2005-252300(Kokai), and JP-A-2006-128227(Kokai)).

However, the mesh electrode is periodically interrupted, and hence the main route as illustrated in FIG. 2A is difficult to form, which makes it difficult to supply a current into the light emitting device from its center. Furthermore, the mesh configuration does not serve to partially reduce the conductivity in the electrode. Hence, light emission may be eventually biased to the p-side electrode or the n-side electrode.

The striped electrode produces light emission with a line-and-space pattern, which makes it difficult to achieve a uniform emission distribution. Furthermore, even in a striped electrode, each electrode line does not include the aforementioned notch 300a, and hence eventually undergoes current concentration illustrated in FIG. 2B.

In a comb-like electrode, the electrode itself is not planar, but a plurality of thin electrode lines are extended in a striped configuration from a main electrode, or the trunk of the comb-like electrode. In such a configuration, the electrode line itself is thinned, and the current may fail to flow sufficiently to its end. For instance, the current may fail to be distributed to the four corners of the light emitting device of this configuration. Furthermore, because of the comb-like configuration of the electrode, light emission has a line-and-space pattern. Hence, the emission distribution is not as good as in the semiconductor light emitting device 1.

In contrast, in the semiconductor light emitting device 1, a planar electrode 300 is placed on the p-type GaN layer 70, and includes a first region 300A including the notch 300a, a second region 300B without the notch around the n-side electrode 100, and a third region 300C without the notch around the p-side electrode 200. A current is passed along a main route near the line a at the center of the semiconductor light emitting device 1. While the flow of this current is partially controlled in the electrode 300 by the notch 300a, the current is passed evenly from any position of the main route in the direction from the p-type GaN layer 70 to the n-type GaN layer 30 side. Furthermore, because the electrode 300 includes no notch around the n-side electrode 100 and the p-side electrode 200, the current is sufficiently diffused to the four corners of the semiconductor light emitting device 1 near the main electrode.

Thus, the semiconductor light emitting device 1 can be realized as a light emitting device with more uniform emission distribution and high emission efficiency.

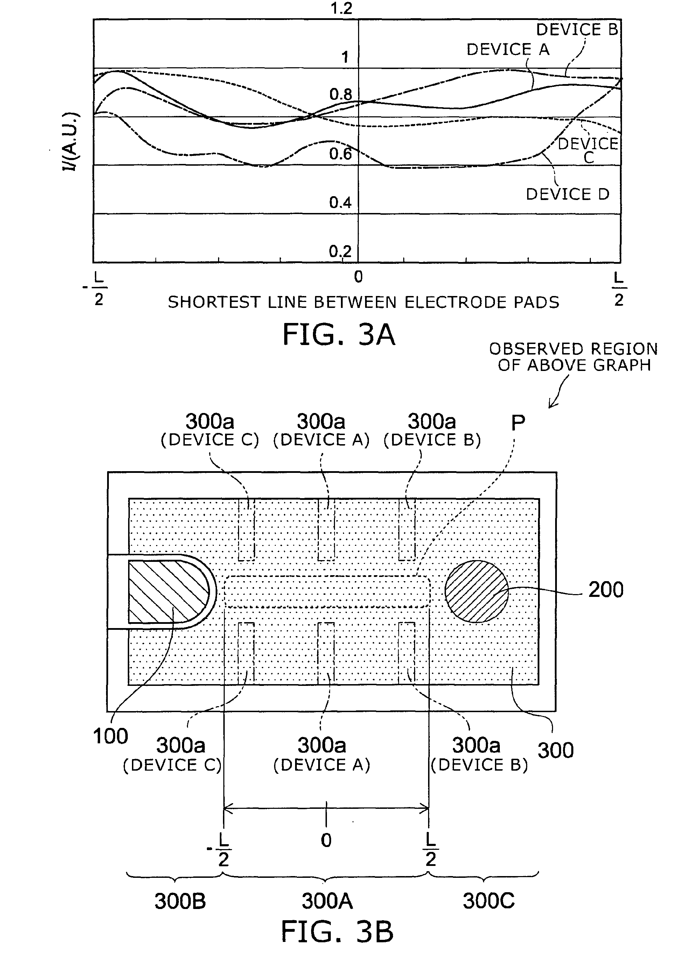

FIGS. 3A and 3B illustrate the emission characteristics of the semiconductor light emitting device. In FIG. 3A, the horizontal axis represents the position of the observed point in the semiconductor light emitting device, and the vertical axis represents the actual measured value (normalized) of emission intensity. The observed portion is a rectangular region P (longitudinal length L) between the p-side electrode 200 and the n-side electrode 100 illustrated in FIG. 3B. The value +L/2 on the horizontal axis of FIG. 3A corresponds to the right end (position +L/2) of the region P, and the value -L/2 on the horizontal axis corresponds to the left end (position -L/2) of the region P. The value L is illustratively 160 µm.

In FIGS. 3A and 3B, the emission characteristics of four semiconductor light emitting devices are illustrated. The four semiconductor light emitting devices are, for instance, a device A including a pair of notches 300a at the center of the semiconductor light emitting device, a device B including a pair of notches 300a on the p-side electrode 200 side of the semiconductor light emitting device, a device C including a pair of notches 300a on the n-side electrode 100 side of the semiconductor light emitting device, and a semiconductor light emitting device D without the notch 300a (see FIG. 3B).

The distance between the notch 300a and the center of the region P in the device B and the device C is illustratively 60 µm.

First, it was found that in the semiconductor light emitting device D without the notch 300a, the emission intensity is high at the right end (position +L/2) of the region P and the left end (position -L/2) of the region P. In this semiconductor light emitting device D, as illustrated in FIG. 2B, current concentration occurs near the n-side electrode 100 and near the p-side electrode 200. Hence, light emission near the n-side electrode 100 and near the p-side electrode 200 dominates. It was found that in the semiconductor light emitting device D, because of the local current concentration, the emission intensity is low throughout the region P except near the n-side electrode 100 and near the p-side electrode 200.

In contrast, it was found that in the semiconductor light emitting device A, the emission intensity is higher throughout the region P than in the semiconductor light emitting device D.

More specifically, it is considered that because the notches 300a formed in the electrode 300 suppress the current path of arrow B illustrated in FIG. 2B, the current is likely to accumulate near the center of the electrode 300. This presumably causes the current to flow from a large region of the electrode 300 to the n-side GaN layer 30 side, increasing the emission intensity throughout the region P.

Thus, the notch 300a provided in the electrode 300 improves the emission distribution and emission efficiency. The emission distribution can be controlled by varying the position of this notch 300a.

For instance, in the semiconductor light emitting device B, the notches 300a are placed on the p-side electrode 200 side. Hence, the effect of current accumulation in the electrode 300 is biased to the p-side electrode 200 side, producing intense light emission on the p-side electrode 200 side. In the semiconductor light emitting device C, the notches 300a are placed on the n-side electrode 100 side. Hence, the effect of current accumulation in the electrode 300 is biased to the n-side electrode 100 side, producing intense light emission on the n-side electrode 100 side. Thus, the emission distribution can be controlled by the position of the notch 300a.

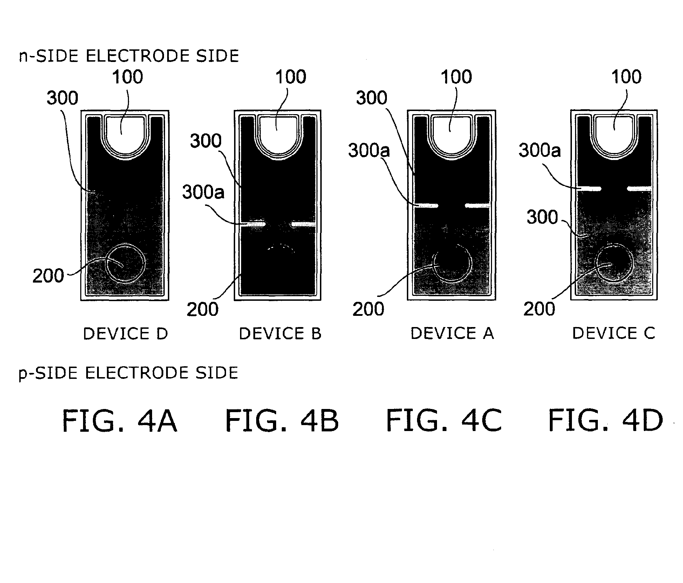

In addition to actual measurement, simulation has also confirmed this effect. The result is shown in FIGS. 4A to 4D.

FIGS. 4A to 4D illustrate the emission characteristics of the semiconductor light emitting devices.

In FIGS. 4A to 4D, the relative intensity of light emitted from the upper surface of the semiconductor light emitting device is shown by shading. A darker shade represents a higher emission intensity.

First, the semiconductor light emitting device D of the comparative example without the notch 300a produces intense light emission on the n-side electrode 100 side (see FIG. 4A). This is because under the condition of the simulation, the electrode 300 is assumed to have low resistance so that the current path B illustrated in FIG. 2B surpasses the current path C.

Next, in the semiconductor light emitting device B, the notches 300a are provided on the p-side electrode 200 side. Hence, the aforementioned effect of current accumulation in the electrode 300 is advanced on the p-side electrode 200 side, increasing the emission intensity on the p-side electrode 200 side (see FIG. 4B).

In the semiconductor light emitting device A, the notches 300a are provided at the center of the electrode 300. Hence, the effect of current accumulation in the electrode 300 is shifted from the p-side electrode 200 side to the center of the electrode 300, producing intense light emission from the p-side electrode 200 side to the center of the electrode 300 (see FIG. 4C).

In the semiconductor light emitting device C, the notches 300a are provided on the n-side electrode 100 side. Hence, the effect of current accumulation in the electrode 300 is shifted to the n-side electrode 100 side, spreading the portion of intense light emission throughout the electrode 300 (see FIG. 4D).

That is, when the n-side electrode 100 side produces relatively intense light emission, the emission distribution can be made more uniform by providing the notch 300a on the n-side electrode 100 side.

On the other hand, it has also been confirmed (not shown) that when the p-side electrode 200 side produces relatively intense light emission, the emission distribution can be made more uniform by providing the notch 300a on the p-side electrode 200 side.

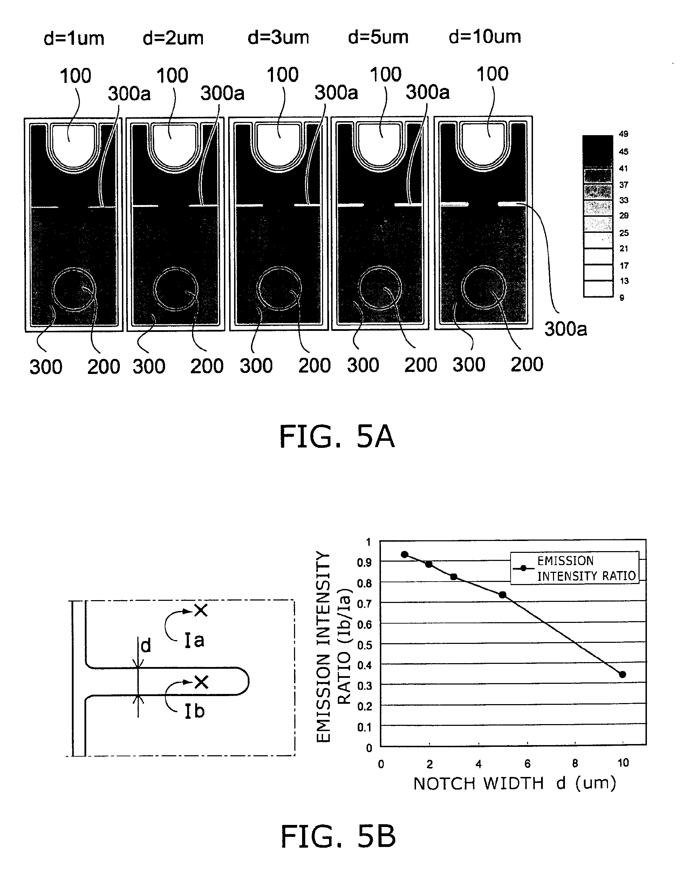

Furthermore, the relationship between the width of the notch 300a and the emission pattern has also been confirmed by simulation. The result is shown in FIGS. 5A and 5B.

FIGS. 5A and 5B illustrate the relationship between the width of the notch and the emission pattern. In FIGS. 5A and 5B, the relative intensity of light emitted from the upper surface of the semiconductor light emitting device is shown by shading. A darker shade represents a more intense light emission.

First, FIG. 5A shows how the emission pattern is varied with the variation of the width of the notch 300a. The width of the notch 300a is illustratively 1 µm, 2 µm, 3 µm, 5 µm, and 10 µm.

As shown by this simulation, when the width d of the notch 300a is 2 µm or less, the emission intensity ratio is close to 90 percent, and the pattern of the notches 300a themselves tends to be obscure. Likewise, when the width d of the notch 300a is 3 µm, the emission intensity ratio is nearly 80 percent, and the pattern of the notches 300a has less influence on the distribution of emission intensity. On the other hand, when the width of the notch 300a is 5 µm or 10 µm, the emission intensity ratio gradually decreases from more than 70 percent, and the pattern is more distinct.

That is, in view of the influence on the emission pattern, the width of the notch 300a is preferably 3 micrometers or less, and more preferably 2 micrometers or less.

FIG. 5B shows the relationship between the width d of the notch 300a and the emission intensity ratio. Here, the emission intensity ratio refers to the ratio Ib/Ia of the emission intensity Ib inside the notch 300a to the emission intensity Ia in the electrode 300.

The result was as follows. Ib/Ia was 0.93 when the width d of the notch 300a was 1 µm. Ib/Ia was 0.88 when the width d was 2 µm. Ib/Ia was 0.83 when the width d was 3 µm. However, Ib/Ia was 0.73 when the width d was 5 µm, and Ib/Ia was 0.32 when the width d was 10 µm.

That is, it was found that Ib/Ia is 0.8 (80%) or more when the width d of the notch 300a is 3 µm or less.

Thus, in the plane of the semiconductor light emitting device 1, the width of the notch 300a which does not affect the emission pattern is preferably 3 µm or less, and more preferably 2 µm or less.

### Second embodiment

Next, variations of the notch pattern are described. In the following, the same components as those of the semiconductor light emitting device 1 are labeled with like reference numerals, and the detailed description thereof is omitted.

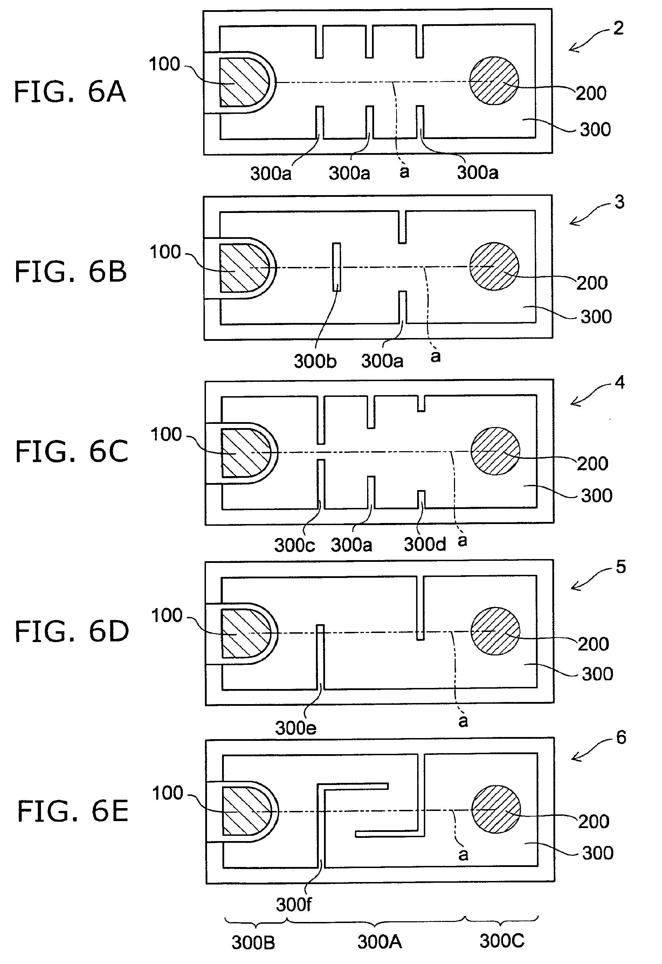

FIGS. 6A to 6E are plan views of the relevant part for describing the variations of the notch pattern.

The semiconductor light emitting device 2 shown in FIG. 6A includes a p-side electrode 200 and an n-side electrode 100. On the upper surface of the p-type GaN layer 70, an electrode 300 extends from the p-side electrode 200 toward the n-side electrode 100. The end of the electrode 300 is arranged so as to surround the periphery of the n-side electrode 100.

The electrode 300 includes three pairs of opposed notches 300a in a direction generally perpendicular to the line a connecting between the center of the p-side electrode 200 and the center of the n-side electrode 100. That is, the electrode 300 includes six notches 300a on both sides. However, the notches 300a do not extend to the position of the line a. That is, the electrode 300 is a continuous body near the line a, and includes a main route of current flow near the line a.

Also in this configuration, the semiconductor light emitting device 2 achieves an operation and effect similar to those of the semiconductor light emitting device 1. In particular, because the semiconductor light emitting device 2 includes a larger number of notches 300a than the semiconductor light emitting device 1, the controllability of the emission distribution is further improved.

The semiconductor light emitting device 3 shown in FIG. 6B includes a p-side electrode 200 and an n-side electrode 100. On the upper surface of the p-type GaN layer 70, an electrode 300 extends from the p-side electrode 200 toward the n-side electrode 100. The end of the electrode 300 is arranged so as to surround the periphery of the n-side electrode 100.

On the p-side electrode 200 side, in a direction generally perpendicular to the line a, the electrode 300 includes two notches 300a which do not extend to the position of the line a. On the n-side electrode 100 side, in a direction generally perpendicular to the line a, the electrode 300 includes a notch 300b crossing astride the line a. That is, a notch 300b adjacent to the two notches 300a is placed inside the electrode 300.

Also in this configuration, the electrode 300 is a continuous body in the portion except the notches 300a, 300b. That is, the semiconductor light emitting device 3 includes a continuous body which can serve as a main route in the direction from the p-side electrode 200 to the n-side electrode 100. Hence, the semiconductor light emitting device 3 also achieves an operation and effect similar to those of the semiconductor light emitting device 1. In particular, in the semiconductor light emitting device 3, the current flowing in the electrode 300 diffuses also to the lateral side of the electrode 300. Hence, the emission efficiency and the controllability of emission distribution are further improved relative to the semiconductor light emitting device 1.

The semiconductor light emitting device 4 shown in FIG. 6C includes a p-side electrode 200 and an n-side electrode 100. On the upper surface of the p-type GaN layer 70, an electrode 300 extends from the p-side electrode 200 toward the n-side electrode 100. The end of the electrode 300 is arranged so as to surround the periphery of the n-side electrode 100.

The electrode 300 includes three pairs of opposed notches 300a, 300c, 300d in a direction generally perpendicular to the line a. That is, the electrode 300 includes six notches on both sides. However, each notch does not extend to the position of the line a. The notches are arranged to narrow the opposed spacing therebetween from the p-side electrode 200 toward the n-side electrode 100, so that the width of the main route of current flow is narrowed from the p-side electrode 200 toward the n-side electrode 100.

Also in this configuration, the electrode 300 is a continuous body in the portion except the notches 300a, 300c, 300d. That is, the semiconductor light emitting device 4 includes a continuous body which can serve as a main route in the direction from the p-side electrode 200 to the n-side electrode 100. Hence, the semiconductor light emitting device 4 also achieves an operation and effect similar to those of the semiconductor light emitting device 1.

In particular, in the semiconductor light emitting device 4, the opposed spacing between the notches (the length of the portion of the electrode 300 between the opposed notches) is varied in the electrode 300. Hence, the controllability of emission distribution is further improved relative to the semiconductor light emitting device 1.

The semiconductor light emitting device 5 shown in FIG. 6D includes a p-side electrode 200 and an n-side electrode 100. On the upper surface of the p-type GaN layer 70, an electrode 300 extends from the p-side electrode 200 toward the n-side electrode 100. The end of the electrode 300 is arranged so as to surround the periphery of the n-side electrode 100.

The electrode 300 includes two notches 300e in a direction generally perpendicular to the line a. However, the two notches 300e are not opposed to each other, but one is placed on the p-side electrode 200 side, and the other is placed on the n-side electrode 100 side. That is, the notch 300e extending into the electrode 300 from one edge of the electrode 300 is placed adjacent to the notch 300e extending into the electrode 300 from the other edge of the electrode 300. Each notch 300e extends to the position of the line a.

Also in this configuration, the electrode 300 is a continuous body in the portion except the notches 300e. That is, the semiconductor light emitting device 5 includes a continuous body which can serve as a main route in the direction from the p-side electrode 200 to the n-side electrode 100. Hence, the semiconductor light emitting device 5 also achieves an operation and effect similar to those of the semiconductor light emitting device 1.

In particular, in the semiconductor light emitting device 5, the current flowing in the electrode 300 diffuses also to the lateral side of the electrode 300. Hence, the emission efficiency and the controllability of emission distribution are further improved relative to the semiconductor light emitting device 1.

The semiconductor light emitting device 6 shown in FIG. 6E includes a p-side electrode 200 and an n-side electrode 100. On the upper surface of the p-type GaN layer 70, an electrode 300 extends from the p-side electrode 200 toward the n-side electrode 100. The end of the electrode 300 is arranged so as to surround the periphery of the n-side electrode 100.

The electrode 300 includes two L-shaped notches 300f. More specifically, in the semiconductor light emitting device 6, from the end of the notch extended inward from the edge of the electrode 300, the notch is extended generally parallel to the direction from the p-side electrode 200 to the n-side electrode 100. However, the two notches 300f are not opposed to each other, but one is placed on the p-side electrode 200 side, and the other is placed on the n-side electrode 100 side.

Also in this configuration, the electrode 300 is a continuous body in the portion except the notches 300f. That is, the semiconductor light emitting device 6 includes a continuous body which can serve as a main route in the direction from the p-side electrode 200 to the n-side electrode 100. Hence, the semiconductor light emitting device 6 also achieves an operation and effect similar to those of the semiconductor light emitting device 1.

In particular, in the semiconductor light emitting device 6, the current flowing in the electrode 300 diffuses in a crank shape at the center of the device. Hence, the emission efficiency is further improved relative to the semiconductor light emitting device 1.

### Third embodiment

Next, an alternative variation of the semiconductor light emitting device and the notch pattern is described.

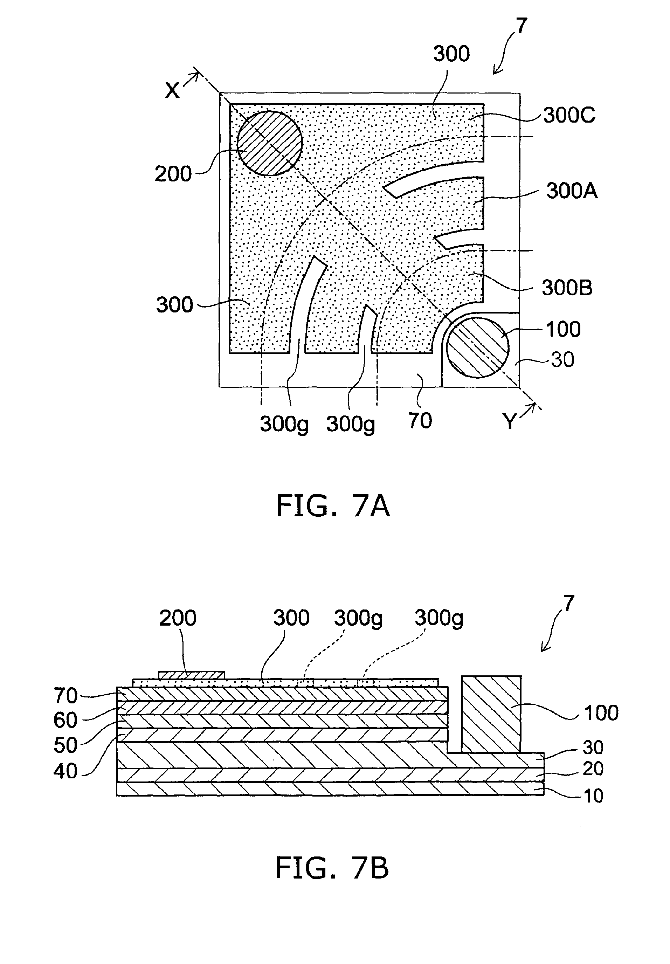

FIGS. 7A and 7B show a relevant part of the semiconductor light emitting device. More specifically, FIG. 7A illustrates the relevant part of the semiconductor light emitting device 7 in plan view, and FIG. 7B illustrates the X-Y cross section of FIG. 7A.

As illustrated in FIGS. 7A and 7B, in the plane of the semiconductor light emitting device 7, the ratio between the longitudinal and lateral length is approximately 1:1. The semiconductor light emitting device 7 has a structure in which a GaN buffer layer 20, an n-type GaN layer 30, an n-type GaN guide layer 40, an active layer 50, a p-type GaN guide layer 60, and a p-type GaN layer 70 are provided in this order on a substrate 10. An n-side electrode 100 as a main electrode is formed on part of the n-type GaN layer 30.

An electrode 300 is placed on the upper surface of the p-type GaN layer 70, and a p-side electrode 200 as a main electrode is placed on part of the electrode 300. That is, the n-side electrode 100 and the p-side electrode 200 are both placed above the major surface of the substrate 10 on which the semiconductor layers are stacked.

At opposed positions in a plane, the semiconductor light emitting device 7 includes the p-side electrode 200 placed above the p-type GaN layer 70 and the n-side electrode 100 placed on the n-type GaN layer 30. The electrode 300 connected to the p-side electrode 200 is formed on the upper surface of the p-type GaN layer 70.

The electrode 300 extends from the p-side electrode 200 to the four corners of the plane of the semiconductor light emitting device 7. Furthermore, at least one notch 300g is provided in part of the electrode 300 of the semiconductor light emitting device 7. The electrode 300 includes a first region 300A including the notch 300g, a second region 300B without the notch around the n-side electrode 100, and a third region 300C without the notch around the p-side electrode 200.

For instance, in the electrode 300, notches 300g are radially placed around the n-side electrode 100. The notch 300g does not extend to the position of the line a connecting between the center of the p-side electrode 200 and the center of the n-side electrode 100. That is, the electrode 300 is a continuous body near the line a. In this electrode 300, a current flows along a main route near the line a. In other words, on the p-type GaN layer 70, a continuous body of ITO film which can serve as a main route of current is ensured in the direction from the p-side electrode 200 to the n-side electrode 100.

The semiconductor light emitting device 7 thus configured also achieves an operation and effect similar to those of the semiconductor light emitting device 1. That is, the notch 300g placed in the electrode 300 advances the effect of current accumulation in the electrode 300, which improves the emission distribution and emission efficiency as described above.

### Fourth embodiment

Next, a description is given of an example in which the emission distribution is improved without providing notches in the electrode 300. This example has been confirmed by simulation.

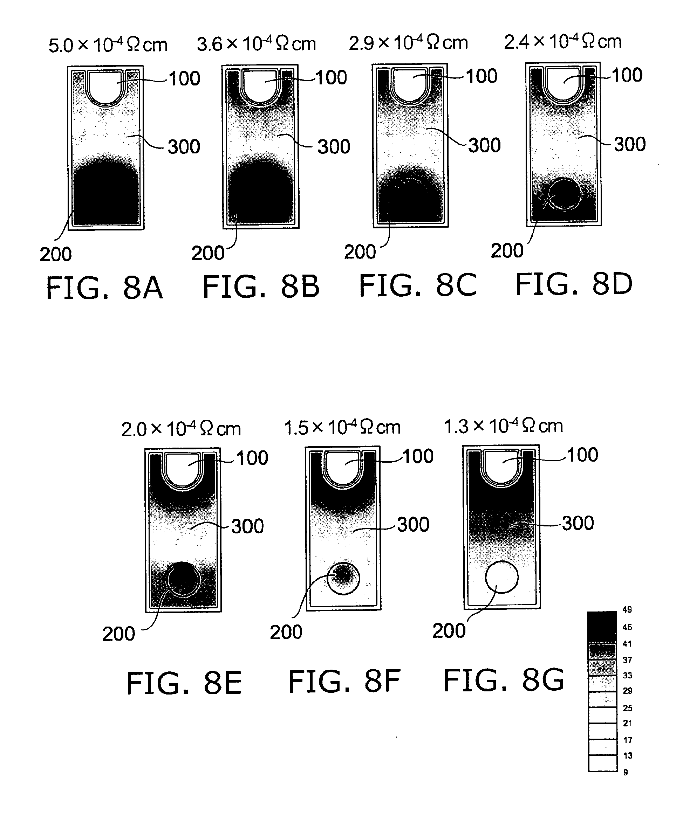

FIGS. 8A to 8G illustrate the emission characteristics of semiconductor light emitting devices.

In FIGS. 8A to 8G, the relative intensity of light emitted from the upper surface of the semiconductor light emitting device is shown by shading. More specifically, a darker shade represents a higher emission intensity.

In the semiconductor light emitting devices illustrated in FIGS. 8A to 8G, the electrode 300 includes no notch. However, the emission distribution thereof is improved by varying the resistance or resistivity of the electrode 300.

For instance, in this figure, the resistance of the electrode 300 is illustratively 5.0×10⁻⁴-1.3×10⁻⁴ Ω·cm.

When the resistance of the electrode 300 is 3.3×10⁻⁴ Ω·cm or more, intense light emission occurs on the p-side electrode 200 side (see FIGS. 8A and 8B). In particular, it is found that as the resistance becomes higher, light emission on the p-side electrode 200 side becomes marked. When the resistance of the electrode 300 is 2.9x 10⁻⁴ Ω·cm, the effect of current accumulation is advanced throughout the electrode 300, and the emission distribution is further improved. That is, intense light emission occurs throughout the electrode 300 (see FIG. 8C).

At 2.0×10⁻⁴ Ω·cm or less, as described above, intense light emission occurs on the n-side electrode 100 side. In particular, this tendency becomes marked as the resistance of the electrode 300 becomes lower (see FIGS. 8D to 8G).

Thus, it is also possible to achieve a good emission distribution without providing notches in the electrode 300. To this end, the resistance of the electrode 300 is preferably 2.0×10⁻⁴-3.3×10⁻⁴ Ω·cm. More preferably, the resistance of the electrode 300 is 2.9x 10⁻⁴ Ω·cm.

The embodiments have been described with reference to examples. However, the above embodiments can be combined with each other. Furthermore, the embodiments are not limited to the above examples.

For instance, the semiconductor multilayer structure is not limited to GaN-based ones, but can be made of various compound semiconductors including InGaAlP-based, GaAlAs-based, and ZnSe-based ones.

Light emitted from the semiconductor light emitting device is not limited to visible light, but can be ultraviolet or infrared light. For instance, ultraviolet or blue light in combination with phosphors dispersed in a sealing resin can be used for wavelength conversion to produce white light.

Furthermore, those skilled in the art can variously modify the shape, size, material, layout and the like of the substrate, the semiconductor layer, the composition of the semiconductor layer, the electrode, and other components constituting the semiconductor light emitting device, and such modifications are also encompassed within the scope of the invention as long as they fall within the spirit of the invention.

## Claims

1. A semiconductor light emitting device comprising:
a semiconductor multilayer structure including a first semiconductor layer, a second semiconductor layer, and a light emitting layer provided between the first semiconductor layer and the second semiconductor layer;
a first electrode connected to the first semiconductor layer of the semiconductor multilayer structure;
a second electrode provided on the second semiconductor layer of the semiconductor multilayer structure; and
a third electrode connected to the second electrode,
the second electrode being provided between the first electrode and the third electrode as viewed in a direction perpendicular to a major surface of the semiconductor multilayer structure, and including:
a first region having at least one notch extending toward a route connecting between the first electrode and the third electrode;
a second region provided around the first electrode and having no notch; and
a third region provided around the third electrode and having no notch.

2. The device according to claim 1, wherein the first region includes a first said notch extending from one edge of the second electrode into the second electrode, and a second said notch extending from the other edge of the second electrode into the second electrode, the notches being opposed to each other.

3. The device according to claim 1, wherein the first region includes the notch which is provided so as to cross a center line connecting between the first electrode and the third electrode.

4. The device according to claim 1, wherein the first region includes a plurality of the notches which are arranged in a direction from the third electrode to the first electrode with the opposed spacing therebetween being varied.

5. The device according to claim 1, wherein the second electrode has a lower resistivity than the second semiconductor layer.

6. The device according to claim 1, wherein the notch does not reach a center line connecting between the first electrode and the third electrode as viewed in the direction perpendicular to the major surface.

7. The device according to claim 1, wherein the first region includes a first said notch extending from one edge of the second electrode into the second electrode, and a second said notch extending from the other edge of the second electrode into the second electrode, the notches not being opposed to each other.

8. The device according to claim 7, wherein the notch extends to a center line connecting between the first electrode and the third electrode as viewed in the direction perpendicular to the major surface.

9. The device according to claim 8, wherein the notch extends to the center line connecting between the first electrode and the third electrode, and further extends generally parallel to a direction from the third electrode to the first electrode, as viewed in the direction perpendicular to the major surface.

10. The device according to claim 1, wherein the notch has a width of 3 micrometers or less.

11. The device according to claim 1, wherein the first electrode is selectively provided on the first semiconductor layer, and the first electrode is exposed to the major surface side of the semiconductor multilayer structure where the second electrode is provided.

12. The device according to claim 1, wherein the second electrode extends from the third electrode toward the first electrode.

13. The device according to claim 1, wherein the second electrode has an end which is arranged so as to surround the periphery of the first electrode.

14. The device according to claim 1, wherein the third electrode is selectively provided on the second electrode.

15. The device according to claim 1, wherein the second electrode is a metal film or an indium tin oxide film.
